Europäisches Patentamt

European Patent Office

Office européen des brevets

(11) Numéro de publication: **0 285 483 B1**

# (12) FASCICULE DE BREVET EUROPEEN

(45) Date de publication de fascicule du brevet: **12.08.92**   (51) Int. Cl.5: **H03F 3/191**, H03F 1/34

(21) Numéro de dépôt: **88400606.5**

(22) Date de dépôt: **15.03.88**

(54) **Amplificateur à large bande et faible bruit en ondes métriques.**

(30) Priorité: **20.03.87 FR 8703923**

(43) Date de publication de la demande:
**05.10.88 Bulletin 88/40**

(45) Mention de la délivrance du brevet:
**12.08.92 Bulletin 92/33**

(84) Etats contractants désignés:
**CH DE GB IT LI**

(56) Documents cités:
**EP-A- 0 184 483**
**FR-A- 1 263 401**
**FR-A- 1 295 540**
**GB-A- 849 316**

(73) Titulaire: **THOMSON-CSF**
**51, Esplanade du Général de Gaulle**
**F-92800 Puteaux(FR)**

(72) Inventeur: **Collin, Robert**
**THOMSON-CSF SCPI 19, avenue de Messine**
**F-75008 Paris(FR)**

(74) Mandataire: **Lincot, Georges et al**
**THOMSON-CSF SCPI**
**F-92045 PARIS LA DEFENSE CEDEX 67(FR)**

## Description

La présente invention concerne un amplificateur à large bande et faible bruit en ondes métriques. Elle s'applique notamment à la réalisation de récepteurs fonctionnant à proximité d'antennes d'émetteurs.

Classiquement ce type d'amplificateur comporte un transistor monté en émetteur commun, associé à un transformateur de contre-réaction entre la sortie et l'entrée de l'amplificateur, c'est-à-dire entre le collecteur du transistor et sa base. Ce montage permet d'obtenir une tension haute fréquence élevée aux bornes du transformateur, mais les capacités parasites des enroulements de contre-réaction limitent la bande passante.

Une solution à ce problème a été décrite par la Demanderesse dans la demande de brevet français n° 84 17295. L'amplificateur qui y est décrit comporte un transistor associé à un circuit de contre-réaction, comportant deux transformateurs. Le primaire du premier transformateur est branché entre l'émetteur du transistor et sa base, le primaire du second transformateur est branché entre le collecteur du transistor et le point de potentiel commun. Les secondaires des deux transformateurs sont reliés en série avec le circuit d'émetteur du transistor. Le signal de sortie de l'amplificateur est prélevé sur une partie du primaire du second transformateur et le nombre de spires des deux secondaires est très faible pour limiter les inductances de fuite.

On obtient dans ces conditions un gain inverse de l'amplificateur à peu près identique et de signe contraire à son gain direct. Mais il résulte du couplage des circuits de source et de charge des problèmes d'adaptation des circuits de source et de charge qui sont difficilement maîtrisables lorsque notamment ces circuits sont constitués par des filtres, la désadaptation des circuits entraînant des modifications des courbes de réponse.

Le but de l'invention est de pallier les inconvénients précités.

A cet effet, l'invention a pour objet, un amplificateur à large bande et faible bruit en ondes métriques comportant un transistor en montage émetteur commun relié par son émetteur à la masse d'alimentation de l'amplificateur à travers deux enroulements secondaires, reliés en série, d'un premier et d'un deuxième transformateurs et couplé entre sa base et son émetteur par l'enroulement primaire du premier transformateur, une extrémité de l'enroulement primaire du deuxième transformateur étant reliée au collecteur du transistor et l'autre extrémité à l'alimentation, la sortie de l'amplificateur étant prélevée sur tout ou partie de l'enroulement primaire du deuxième transformateur et le nombre de spires des enroulements secondaires des transformateurs étant très faible pour limiter l'inductance de fuite caractérisé en ce qu'il comprend une première résistance reliée en série avec les deux enroulements secondaires et une deuxième résistance reliée entre ladite sortie de l'amplificateur et la base du transistor, lesdites résistances étant calculées en fonction des rapports de transformation des deux transformateurs et des impédances d'entrée et de sortie de façon à partager dans un rapport déterminé la tension d'entrée appliquée à la base du transistor, sur la première résistance et l'enroulement secondaire du deuxième transformateur relié en série avec la première résistance.

D'autres caractéristiques et avantages de l'invention apparaîtront ci-après à l'aide de la description faite en regard des dessins annexés qui représentent :
- la figure 1 un schéma électrique de principe d'un mode de réalisation de l'amplificateur selon l'invention ;
- la figure 2 une adaptation du schéma de la figure 1 à la réalisation d'un amplificateur de réception d'ondes métriques ou VHF à large bande et à faible bruit.

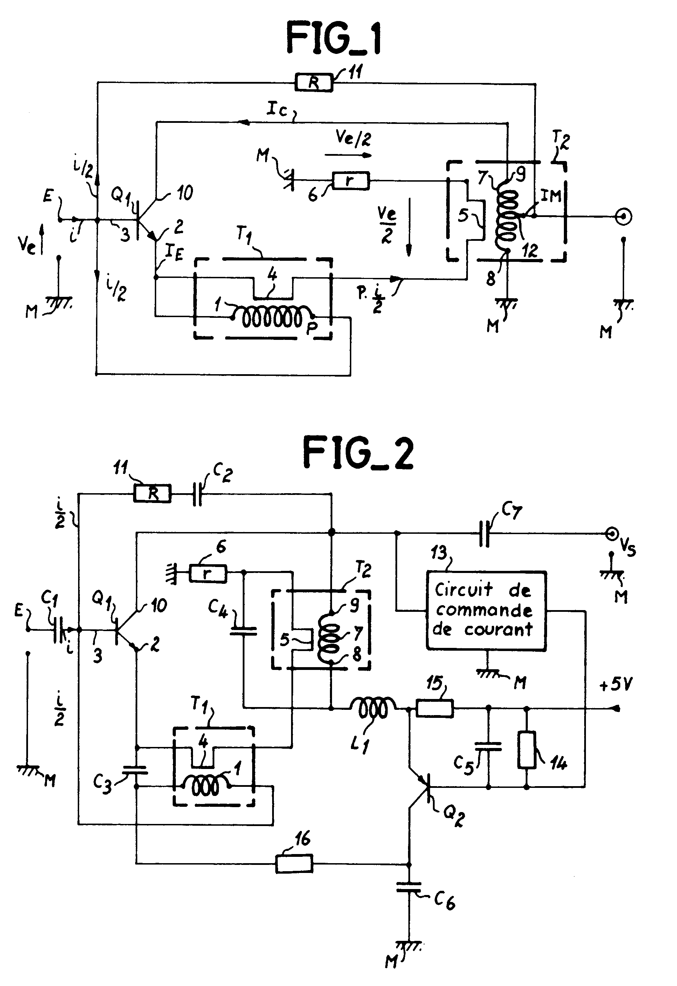

L'amplificateur qui est représenté à la figure 1 organisé autour d'un circuit de masse M servant de référence de potentiel, comprend, un transistor Q1 couplé à un circuit de contre-réaction formé par deux transformateurs T1 et T2 représentés à l'intérieur de lignes en pointillés. L'enroulement primaire 1 du transformateur T1 est disposé entre l'émetteur 2 et la base 3 du transistor Q1. L'émetteur 2 est relié au circuit de masse M au travers d un enroulement secondaire 4 du transformateur T1, d'un enroulement secondaire 5 du transformateur T2, et d'une résistance 6 de valeur r, l'ensemble de ces trois éléments étant reliés dans cet ordre en série entre l'émetteur 2 et le circuit de masse M. Le transformateur T2 possède un enroulement primaire 7 dont les extrémités 8 et 9 sont reliées respectivement, d'une part, au circuit de masse M, au travers éventuellement une source d'alimentation en continu de l'amplificateur, non représentée, et d'autre part, au collecteur 10 du transistor Q1. Une résistance 11 de contre-réaction de valeur R relie une prise intermédiaire 12 du primaire du transformateur T1 à la base 3 du transistor Q1. La tension Ve à amplifier est appliquée entre la base 3 et le circuit de masse M. La tension de sortie Vs est prélevée entre la prise intermédiaire 12 et le circuit de masse M.

Pour ne pas introduire une inductance de fuite trop importante dans le circuit d'émetteur du transistor Q1 les deux secondaires 4 et 5 sont formés chacun par un enroulement comportant une seule spire. L'enroulement primaire 1 du transformateur T1 comprend p spires et l'enroulement primaire du transformateur T2 comprend N spires. L'enroulement primaire 7 du transformateur T2 comprend, entre son extrémité 8 et le point intermédiaire 12, M spires aux bornes desquelles est prélevée la tension de sortie $V_s$ de l'amplificateur.

Le fonctionnement de l'amplificateur est décrit ci-après dans l'hypothèse où le transistor Q1 est un transistor idéal, c'est-à-dire que son impédance d'entrée $Z_e$ est infinie dans le montage considéré et que sa tension base-émetteur est nulle. Dans ces conditions, la tension aux bornes de l'enroulement secondaire 4 est nulle et la tension $V_e$ se retrouve partagée dans le circuit d'émetteur aux bornes de l'enroulement secondaire 5 et de la résistance 6 de valeur r. Dans l'exemple de réalisation de la figure 1, la valeur r est déterminée pour que la tension $V_e$ se partage également aux bornes de la résistance 6 et dans l'enroulement secondaire 5. La tension de sortie $V_s$ est égale à $-M(V_e/2)$ ce qui donne un gain G en tension de l'amplificateur de $-M/2$. De même la valeur R de la résistance 11 est déterminée pour que le courant i engendré à l'entrée de l'amplificateur par la tension $V_e$ se partage également en deux courants d'intensité i/2 dans les deux branches du circuit formé par la résistance 11 et l'enroulement primaire 1. Le courant circulant dans la spire de l'enroulement secondaire 4 est alors égal à p.i/2 et il est aussi égal au courant qui circule dans l'enroulement secondaire 5. Le courant d'émetteur circulant dans le transistor est donc égal dans ces conditions à

$$I_E = p.i/2 - i/2 \text{ soit } I_E = (p-1).i/2 \qquad (1)$$

Comme dans l'hypothèse le courant $I_b$ circulant dans la base du transistor Q1 est nul, le courant collecteur $I_c$ est égal au courant d'émetteur $I_E$, on a donc :

$$I_c = (p-1).i/2 \qquad (2)$$

En écrivant que le nombre d'ampères tours produit par les courants dans le primaire et dans le secondaire du transformateur T2 sont opposés on obtient la relation :

$$p.i/2.1 = -|(p-1).i/2.N - M.i_M| \qquad (3)$$

où $i_M$ désigne le courant entrant par la prise intermédiaire 12.

Si on prend encore pour hypothèse que les impédances $Z_0$ d'entrée et de sortie de l'amplificateur sont identiques on obtient :

$$V_s/i_s = V_e/i = Z_0 \qquad (4)$$

où $i_s$ désigne le courant de sortie de l'amplificateur.

Comme $V_s = (-M/2).V_e$, la relation (4) est vérifiée si $i_s$ est égale à $(M/2).i$, d'où il résulte $i_M = (M/2).i + i/2 = (M+1).i/2$. En reportant la valeur de $i_M$ dans l'équation (3), on obtient :

$$N = (M.(M+1)-)P/(p-1) \qquad (5)$$

Comme la valeur de M fixe le gain en tension de l'amplificateur, la relation (5) montre qu'il existe pour chaque valeur de gain fixé un nombre élevé de solutions pour N.

Par exemple, en choisissant un gain en tension $M/2 = 4$, un certain nombre de solutions sont possibles pour le choix des nombres de spires P et N des primaires des transformateurs T1 et T2 :

avec $M = 8$, l'expression (5) devient

$N = (72-p)/(p-1)$ et les solutions suivantes sont possibles :

si     p = 2, N = 70
si     p = 3, N = 34,5
si     p = 4, N = 22,6
si     p = 5, N = 16,7
si     p = 6, N = 13,4
si     p = 7, N = 10,8
si     p = 8, N = 9,1
si     p = 9, N = 7,8

En se fixant, par exemple, la solution $M = 8$, p = 9 et N arrondi à 8 (M = N) et pour $Z_0$ la valeur 50 ohms on obtient

$$R = (V_e + (M/2).V_e)/(i/2) = 2.Z_0(G+1) = 500 \text{ ohms}$$

et

$$r = (V_e/2)/(p.(i/2)) = 5,5 \text{ ohms}$$

En pratique on prendra une valeur plus forte pour R de façon à compenser le courant dans la base du transistor et une valeur plus faible pour r pour tenir compte de l'impédance d'entrée de $r_e$.

L'adaptation de l'amplificateur qui vient d'être décrit a la réalisation d'un amplificateur de réception d'ondes métriques large bande, à faible bruit, est représentée à la figure 2 où les éléments homologues à ceux de l'amplificateur représenté à la figure 1 sont désignés par les mêmes repères. En comparaison avec le circuit de la figure 1, l'amplificateur de la figure 2 comporte en plus, des moyens pour adapter la consommation de l'amplificateur aux signaux brouilleurs reçus par exemple d'une antenne d'émission située à proximité, de façon à obtenir à tout moment le meilleur facteur de bruit possible. Toujours par rapport à la figure 1 l'amplificateur comporte en plus, des capacités de liaisons C1, C2 et C3. La capacité C1 relie l'entrée E de l'amplificateur à la base du transistor Q1, la capacité C2 relie l'extrémité 9 de l'enroulement primaire 7 à l'extrémité de la résistance 11 qui n'est pas reliée à la base du transistor Q1, et la capacité C3 relie l'émetteur du transistor Q1 à l'extrémité de l'enroulement primaire 1 qui n'est pas reliée à la base du transistor Q1. Les moyens pour adapter la consommation de l'amplificateur aux signaux brouilleurs sont constitués par un transistor Q2 commandé sur sa base par un circuit de commande au courant 13 dont l'entrée est reliée au collecteur du transistor Q1. La base du transistor Q2 est reliée d'une part, à la sortie du circuit de commande en courant 13 et d'autre part, à l'émetteur du transistor Q2 au travers de deux résistances 14 et 15 montées en série. Dans le mode de réalisation représenté le point commun aux résistances 14 et 15 est polarisé à un potentiel d'alimentation de +5 volts. Une capacité C5 découple la résistance 14. L'extrémité 8 de l'enroulement primaire 7 est reliée d'une part, à l'émetteur du transistor Q2 au travers d'une inductance de choc L1 et d'autre part, au point commun entre la résistance 6 et l'enroulement secondaire 5 par l'intermédiaire d'une capacité de découplage C4. Le collecteur du transistor Q2 est relié à l'extrémité commune à la capacité de découplage C3 et à l'enroulement primaire 1 au travers d'une résistance 16 pour agir sur le courant de base du transistor Q1. Le collecteur du transistor Q2 est d'autre part découplé au circuit de masse par une capacité C6.

Suivant un mode de réalisation particulier de l'invention, un montage conforme à celui de la figure 2 a permis d'obtenir les résultats suivants, pour une bande de fréquences explorées comprises entre 30 et 90 MHz. Les mesures ont été effectuées pour deux consommations de courant, l'une à 7 milliampères et l'autre à 26 milliampères. Dans l'un et l'autre des deux cas on a pu obtenir des gains directs de 10,7 dB et de 11,6 dB et des gains inverses allant de 26 dB à 33 dB en fonction de la fréquence. Pour une consommation de courant I = 7 milliampères, l'impédance d'entrée complexe $Z_e$ a pu être mesurée comprise entre 56 ohms $\times$ Exp.j.5° et 62 ohms $\times$ Exp.j.3°, et l'impédance de sortie $Z_s$ a pu être mesurée comprise entre 58 ohms $\times$ Exp.j.6° et 60 ohms $\times$ Exp.-j4°, le facteur de bruit F étant égal à 2,3 décibels. Pour une consommation de courant I = 26 milliampères l'impédance d'entrée $Z_e$ a pu être mesurée comprise 50 ohms $\times$ Exp.j7° et 60 ohms $\times$ Exp.j11° et l'impédance de sortie $Z_s$ a pu être mesurée comprise entre 51 ohms $\times$ Exp.j.7° et 57 ohms $\times$ Exp.j.2°, le facteur de bruit étant égal à 2,5 décibels. Par ailleurs avec le courant élevé de 26 milliampères le point de compression à 1 décibel a été obtenu pour une tension d'entrée de 280 millivolts.

Il va de soi que l'invention n'est pas limitée aux modes de réalisation précédemment décrits. D'autres variantes, sont naturellement possibles dépendant notamment des performances en fréquences, bande passante, rapport signal à bruit, que l'on souhaite obtenir et l'homme de l'art conviendra aisément que les réalisations des figures 1 et 2 pourront très bien subir des modifications en fonction des besoins, sans sortir du cadre de l'invention.

## Revendications

1. Amplificateur à large bande et faible bruit en ondes métriques comportant un transistor (Q1) en montage émetteur commun relié par son émetteur à la masse (M) d'alimentation de l'amplificateur à travers deux enroulements secondaires (4, 5), reliés en série, d'un premier (T1) et d'un deuxième (T2) transformateurs et couplé entre sa base et son émetteur par l'enroulement primaire du premier transformateur (T1), une extrémité (9) de l'enroulement primaire (7) du deuxième transformateur (T2) étant reliée au collecteur du transistor (Q1) et l'autre extrémité (8) à l'alimentation, la sortie (12) de l'amplificateur étant prélevée sur tout ou partie de l'enroulement primaire (7) du deuxième transformateur (T2) et le nombre de spires des enroulements secondaires (4 et 5) des transformateurs (T1, T2) étant très faible pour limiter l'inductance de fuite caractérisé en ce qu'il comprend une première résistance (6) reliée en série avec les deux enroulements secondaires (4, 5) et une deuxième résistance (11) reliée entre ladite sortie (12) de l'amplificateur et la base du transistor, lesdites résistances étant calculées en fonction des rapports de transformation des deux transformateurs et des impédances d'entrée et de sortie de façon à partager dans un rapport déterminé la tension d'entrée appliquée à la base du transistor sur la première résistance et l'enroulement secondaire (5) du deuxième transformateur (T2) relié en série avec la première résistance.

2. Amplificateur selon la revendication 1, caractérisé en ce que les enroulements secondaires (4, 5) et deux transformateurs (T1, T2) comportent chacun une seule spire.

3. Amplificateur selon les revendications 1 et 2, caractérisé en ce que le gain en tension de l'amplificateur est égal à -M/2, la tension de sortie étant prélevée aux bornes de M spires du primaire (7) du deuxième transformateur (T2), les primaires des deux transformateurs comportant respectivement p et N spires, p, M, N étant des nombres entiers satisfaisant l'expression N = (M(M + 1)-p)/(p-1)

4. Amplificateur selon l'une quelconque des revendications 1 à 3, caractérisé en ce que le nombre M est égal au nombre N.

5. Amplificateur selon l'une quelconque des revendications 1 à 4, caractérisé en ce qu'il comporte en outre un circuit de commande en courant (13) du transistor (Q1) pour réguler la consommation en courant de l'amplificateur en fonction de l'amplitude de signaux brouilleurs éventuellement reçus pour obtenir à tout moment le meilleur facteur de bruit possible.

**Claims**

1. Broad-band and low noise VHF amplifier comprising a transistor (Q1) as a common emitter assembly connected via its emitter to the power supply earth (M) of the amplifier by means of two secondary windings (4, 5), connected in series, of a first (T1) and a second (T2) transformer and coupled between its base and its emitter by the primary winding of the first transformer (T1), one end (9) of the primary winding (7) of the second transformer (T2) being connected to the collector of the transistor (Q1) and the other end (8) being connected to the power supply, the amplifier output (12) being tapped from all or part of the primary winding (7) of the second transformer (T2) and the number of turns of the secondary windings (4 and 5) of the transformers (T1, T2) being very small in order to limit the leakage inductance characterised in that it comprises a first resistor (6) connected in series with the two secondary windings (4, 5) and a second resistor (11) connected between said amplifier output (12) and the base of the transistor, said resistors being calculated as a function of the turn ratios of the two transformers and the input and output impedances so as to divide the input voltage applied to the base of the transistor on the first resistor and the secondary winding (5) of the second transformer (T2) connected in series with the first resistor into a specific ratio.

2. Amplifier according to claim 1, characterised in that the secondary windings (4, 5) and two transformers (T1, T2) each have a single turn.

3. Amplifier according to claims 1 and 2, characterised in that the voltage gain of the amplifier is equal to -M/2, the output voltage being tapped at the M-turn terminals of the primary winding (7) of the second transformer (T2), the primary windings of the two transformers having p and N turns respectively, p, M, N being whole numbers which satisfy the expression N = (M(M + 1)-p)/(p-1).

4. Amplifier according to one of claims 1 to 3, characterised in that the number M is equal to the number N.

5. Amplifier according to one of claims 1 to 4, characterised in that it also contains a current control circuit (13) for the transistor (Q1) in order to regulate the current drain of the amplifier as a function of the amplitude of any unwanted signals which might be received in order to obtain the best possible noise figure at all times.

**Patentansprüche**

1. Ultrakurzwellen-Breitbandverstärker mit geringem Rauschen, mit einem Transistor (Q1) in Emitterschaltung, der mit seinem Emitter über zwei in Reihe geschaltete Sekundärwicklungen (4, 5) eines ersten (T$_1$) und eines zweiten (T$_2$) Transformators mit der Masse (M) der Versorgung des Verstärkers verbunden ist und zwischen dessen Basis und dessen Emitter die Primärwicklung des ersten Transformators (T$_1$) geschaltet ist, wobei ein Ende (9) der Primärwicklung (7) des zweiten Transformators (T$_2$) mit dem Kollektor des Transistors (Q$_1$) und das andere Ende (8) mit der Versorgung verbunden ist, wobei der Ausgang (12) des Verstärkers entweder über der gesamten oder über einem Teil der Primärwicklung (7) des zweiten Transformators (T2) abgegriffen wird und wobei die Anzahl der Windungen der Sekundärwicklungen (4 und 5) der Transformatoren (T$_1$, T$_2$) sehr gering ist, um die Streuinduktivität zu begrenzen, dadurch gekennzeichnet, daß er einen mit den zwei Sekundärwicklungen (4, 5) in Reihe geschalteten ersten Widerstand (6) und einen zwischen den Ausgang (12) des Verstärkers und die Basis des Transistors geschalteten zweiten Widerstand (11) umfaßt, wobei die Widerstände in Abhängigkeit von den Wicklungsverhältnissen der zwei Transformatoren und der Eingangs- und Ausgangsimpedanzen berechnet sind, derart, daß die an die Basis des Transistors angelegte Eingangsspannung über dem ersten Widerstand und über der mit dem ersten Widerstand in Reihe geschalteten Sekundärwicklung (5) des zweiten Transformators (T$_2$) in einem bestimmten Verhältnis geteilt wird.

2. Verstärker gemäß Anspruch 1, dadurch gekennzeichnet, daß die Sekundärwicklungen (4, 5) und die zwei Transformatoren (T$_1$, T$_2$) je-

weils eine einzige Windung aufweisen.

3.    Verstärker gemäß den Ansprüchen 1 und 2, dadurch gekennzeichnet, daß die Spannungsverstärkung des Verstärkers gleich -M/2 ist, wobei die Ausgangsspannung an den Anschlüssen der M Windungen der Primärwicklung (7) des zweiten Transformators ($T_2$) abgegriffen wird, wobei die Primärwicklungen der zwei Transformatoren p bzw. N Windungen besitzen, wobei p, M, N ganze Zahlen sind, die den Ausdruck $N = (M(M+1) - p)/(p-i))$ erfüllen.

4.    Verstärker gemäß einem der Ansprüche 1 bis 3, dadurch gekennzeichnet, daß die Anzahl M gleich der Anzahl N ist.

5.    Verstärker gemäß einem der Ansprüche 1 bis 4, dadurch gekennzeichnet, daß er außerdem eine Stromsteuerschaltung (13) des Transistors ($Q_1$) umfaßt, um den Stromverbrauch des Verstärkers in Abhängigkeit von der Amplitude der eventuell empfangenen Störsignale zu steuern, um in jedem Moment die bestmögliche Rauschzahl zu erhalten.

# FIG_1

# FIG_2

7